# EUROPEAN PATENT APPLICATION

(11) **EP 2 061 156 A1**
(43) Date of publication of application: **20.05.2009**
(21) Application number: 08166890.7
(22) Date of filing: 17.10.2008
(51) Int. Cl.: H04B 1/38, H04B 1/18

(54) **Wireless communication modules and devices**

(30) Priority: 16.11.2007 TW 96143435
(71) Applicant: High Tech Computer, Corp., Taoyuan City Taoyuan County 330 (TW)
(72) Inventor: Chen, Wan-Ming, 330,, Taoyuan City, Taoyuan County (TW); Tung, Wei-Shin, 330, Taoyuan City, Taoyuan County (TW); Su, Chih-Chin, 330, Taoyuan City, Taoyuan County (TW); Huang, Ming-San, 330, Taoyuan City, Taoyuan County (TW)
(74) Representative: 2K Patentanwälte Blasberg Kewitz & Reichel

(57) **Abstract**

A wireless communication module is proposed, in which an LTCC substrate is employed. The LTCC substrate comprises at least a first layer and a second layer. At least first and second communication elements are deposited on the first layer, and a matching network is embedded in the second layer. The matching network couple the first and second communication elements to provide matched impedance, such that radio frequency signals are transmitted without distortion. Specifically, the first layer is the surface of the LTCC substrate, whereas the second layer is a depth inside the LTCC substrate. The matching network comprises at least one inductance or capacitance buried in the second layer.

## Description

### BACKGROUND OF THE INVENTION

### CROSS REFERENCE TO RELATED APPLICATIONS

This Application claims priority of Taiwan Patent Application No. 96143435, filed on Nov. 16, 2007, the entirety of which is incorporated by reference herein.

### Field of the Invention

The invention relates to wireless communications, and in particular, to a wireless communication module having matching networks implemented on a Low-Temperature Cofired Ceramics (LTCC) substrate.

### Description of the Related Art

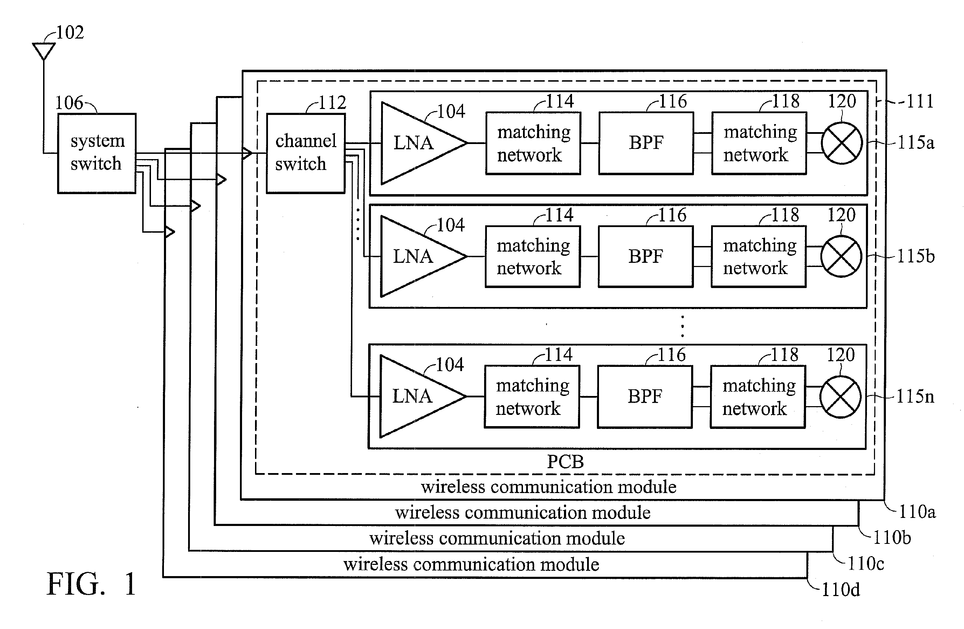

Fig. 1 shows a conventional receiver comprising a plurality of wireless communication modules. The receiver is implemented based on printed circuit board (PCB) architecture. As the demand for wireless communication grows, various different wireless communication modules or systems such as 3.5G, GPS, WiFi and Bluetooth may be integrated in one mobile device such as a cell phone or a PDA. As shown in Fig. 1, there are multiple receivers 110a to 110d sharing one antenna 102, and their functionalities are switched by a system switch 106. Each receiver may be designed to process a plurality of channels. For example, the receiver 110a comprises a plurality of RF modules 115a to 115n each handling a different channel. One of the RF modules 115a to 115n is enabled by a channel switch 112 to receive the RF signal sent from the system switch 106. An RF module 115a may comprise a low noise amplifier (LNA) 104, a band pass filter (BPF) 116 and an antenna 102. The LNA 104 amplifies the RF signal sent from the system switch 106, and the BPF 116 filters the output from the LNA 104 to eliminate unwanted noise terms. Thereafter, the mixer 120 down converts the filtered signals to generate an intermediate signal or a baseband signal and outputs the signals for further processes such as digitalization in an ADC (not shown). The RF module 115a may further comprise many other essential components that can be found in prior arts, so detailed descriptions are not provided herein.

In conventional architecture, impedance mismatch between the BPF 116 and the mixer 120 may degrade quality of signal transmission, thus, conventionally, a matching network 118 is deployed between the BPF 116 and the mixer 120 to compensate for impedance mismatch. The same problem occurs between the BPF 116 and LNA 104, so a matching network 114 is also required to match their impedances. Generally speaking, impedance mismatch exists between any two elements in the RF modules 115a to 115n, so matching networks are essential components in such an architecture.

In the receiver 110a, all the RF modules 115a to 115n are deposited on the surface of a PCB 111 using discrete components. The PCB 111 may be a multi-layered structure such as FR4. Due to natural limitations of materials, when all components are deposited together, circuit complexity, weight and area size are increased, and consequently, system stability and performance are influenced. As market requirements continue to trend toward more compact and light weighted products, the area size issue for a PCB 111 has become a technical bottleneck to be solved.

Additionally, a matching network is typically formed by inductors and capacitors which are market offered components, and only specific parameters are available. A matching network implemented by the components of specific parameters is not flexible enough to fully compensate various impedance mismatches. For these reasons, an enhanced architecture for a circuit board is desirable.

### BRIEF SUMMARY OF THE INVENTION

An exemplary embodiment of a wireless communication module is implemented based on an LTCC substrate comprising at least first and second layers. First and second communication units are deposited at the first layer, and a matching network is deposited at the second layer, coupled to the first and second units to match impedances therebetween. In this way, signals are correctly transmitted to and from the first and second communication units. The first layer is at the surface of the LTTC substrate, and the second layer is at a depth inside the LTCC substrate. The matching network comprises at least an inductor or a capacitor embedded in the second layer.

In one embodiment, the first and second communication units are selected from an LNA, a bandpass filter and a down conversion mixer. Alternatively, the first and second communication units may be selected from a power amplifier, a bandpass filter and an up conversion mixer.

Another embodiment provides a wireless communication device, employing the same structure, comprising a plurality of receivers coupled to the antenna. At least one of the receivers is deposited on the LTCC substrate, comprising a plurality of RF modules each associated with a channel, and one of the RF modules comprises a first communication unit and a second communication unit deposited at the first layer, and a matching network deposited at the second layer.

Further embodiments are transmitters and receivers employing the same structure. A detailed description is given in the following embodiments with reference to the accompanying drawings.

### BRIEF DESCRIPTION OF THE DRAWINGS

The invention can be more fully understood by reading the subsequent detailed description and examples with references made to the accompanying drawings, wherein:

Fig. 1 shows a conventional communication device implemented based on a conventional PCB architecture;

Fig. 2 shows an embodiment of a communication device implemented on an LTCC substrate;

Fig. 3 is a cross-sectional view of the embodiment according to Fig. 2;

Fig. 4a shows an embodiment of a matching network 410; and

Fig. 4b shows an embodiment of a matching network 420.

### DETAILED DESCRIPTION OF THE INVENTION

The following description is of the best-contemplated mode of carrying out the invention. This description is made for the purpose of illustrating the general principles of the invention and should not be taken in a limiting sense. The scope of the invention is best determined by reference to the appended claims.

Low-Temperature Cofired Ceramics (LTCC) is a substrate material for circuit boards with electrodes made by silver, gold or copper. Passive elements such as capacitor, resistors, filters, matching networks and couplers can be buried inside the LTCC substrate using a parallel printed coating process in a 900 degrees centigrade debinding oven to organize an integrated ceramic product.

LTCC technologies have been widely adopted because ceramic has similar material features with silicon, and is particularly suitable to be combined with integrated circuits. Area size is significantly reduced as well as the costs, and passive components are buried in a three-dimensional high density structure, so the modules made therefrom can be easily packaged. LTCC integrated components can be flexibly made into various substrate based or active/passive component embedded products, so the applicable product type covers a wide range comprising component, substrate or module. Because the LTCC substrate uses ceramic as the dielectric material which features high-Q and high frequency range, it is particularly adaptable for high frequency communication applications.

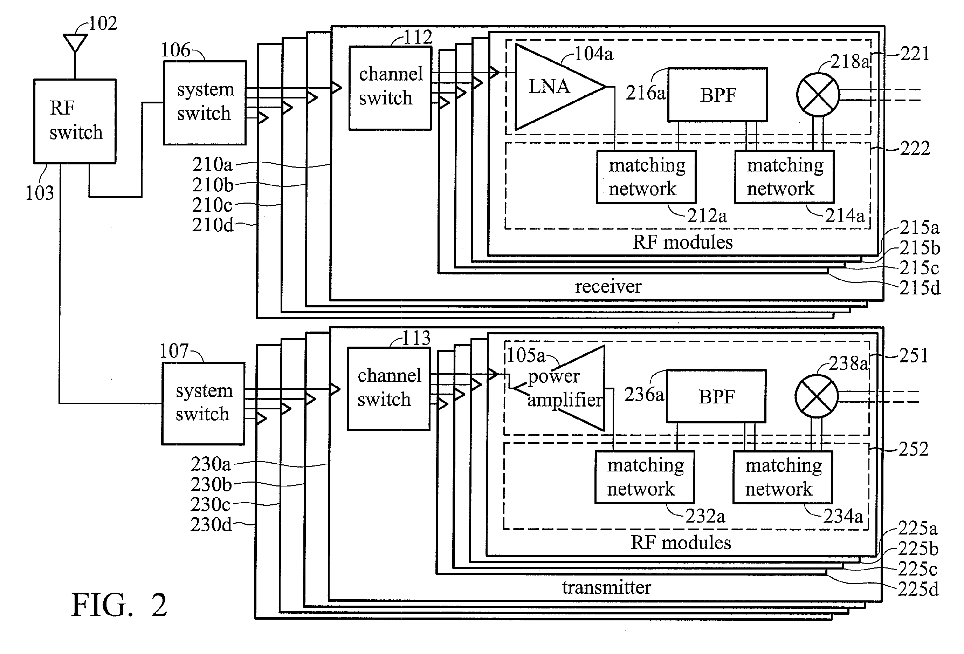

Fig. 2 shows an embodiment of a communication device based on the LTCC architecture. The communication device mainly comprises a transmitter and a receiver. There may be a plurality of receivers (210a to 210d) each specifically designed for different communication applications such as WCDMA, GPS, WiFi or Bluetooth. Symmetrically, there may be a plurality of transmitters (230a to 230d) in the communication device. In the embodiment, the transmitters and receivers share one common antenna 102. An RF switch 103 selectively switches the communication device between a transmitting mode and a receiving mode. In the receiving mode, an incoming RF signal is sent to one of the receivers 210a to 210d via a system switch 106. Conversely, in the transmitting mode, an outbound RF signal is issued from one of the transmitters 230a to 230d, and is sent to the RF switch 103 via the system switch 107 before transmission through the antenna 102.

In each of the receivers, there may be more than one RF modules for handling signals from different channels. As an example, the receiver 210a may comprise four RF modules 215a to 215d, and a channel switch 112 selectively enabling one of the RF modules to receive RF signals from the system switch 106. The channel switch 112 may not be an essential component in the embodiment, and the four RF modules may be able to operate concurrently. The RF modules 215a to 215d are made by LTCC substrates. Specifically, all the RF modules 215a to 215d may be deposited on one LTCC substrate. The LTCC substrate comprises at least two layers, the surface 221 and a depth inside 222. General communication components such as an LNA 104a, BPF 216a and mixer 218a are deposited on the surface 221, and all the matching networks 212a and 214a are buried in the depth inside 222. The matching network 212a is dedicated to compensate impedance mismatches between the LNA 104a and the BPF 216a, and the matching network 214a is particularly adapted between the BPF 216a and the mixer 218a. The communication components are not limited by Fig. 2, and any communication component that can be found in prior arts such as a variable gain amplifier (VGA) or a LPF is suitable for the structure disclosed in the embodiment. A matching network is an essential element between any two communication components, so any communication device with matching networks buried in the depth inside 222 belongs to the scope of the invention.

As to the transmitters, there may also be a plurality of RF modules implemented in one transmitter. As an example, the transmitter 230a comprises a plurality of RF modules 225a to 225d, each handling a different channel. In some applications, the transmitter 230a may use an RF switch 113 to selectively enable one of the RF modules 225a to 225d and output an outbound RF signal sent therefrom. Based on the LTCC structure, all the RF modules 225a to 225d are deposited on the same LTCC substrate, with components individually deposited at a surface 251 and a depth inside 252. General communication components such as a power amplifier 105a, BPF 236a and mixer 238a are deposited on the surface 251, and all the matching networks 232a and 234a are buried in the depth inside 252. In the embodiment, the matching network 232a is designed to match impedances between the power amplifier 105a and the BPF 236a, and the matching network 234a is designed to match impedances between the BPF 236a and the mixer 238a.

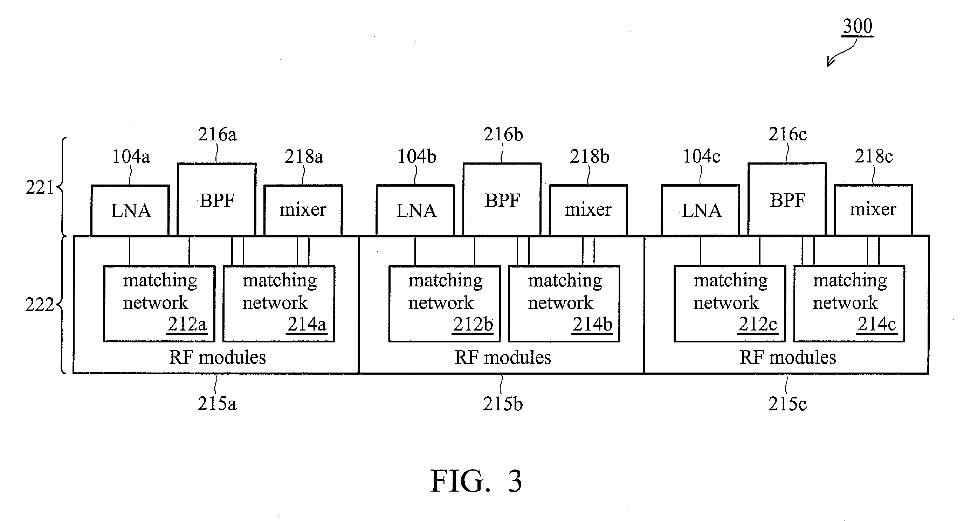

Fig. 3 is a cross-sectional view of the embodiment according to Fig. 2, in which the RF modules 215a, 215b and 215c of Fig. 2 are shown. The RF modules 215a, 215b and 215c are deposited on the same LTCC substrate 300. In the RF module 215a, the LNA 104a, BPF 216a and mixer 218a are deposited on the surface 221 of the LTCC substrate 300. Conversely, the matching network 212a and 214a are buried in the depth inside 222. The matching network 212a is buried in a depth between the LNA 104a and BPF 216a, coupled to both to compensate for their impedance mismatches. Likewise, the matching network 214a is embedded under somewhere between the BPF 216a and mixer 218a, compensating impedance mismatches therebetween. Note that the same structure is applicable for RF modules 215b and 215c, so further description is omitted. From the cross-sectional view, multiple RF modules from different receivers can also be arranged on the same LTCC substrate. Since the matching network 212a, 212b, 212c, 214a, 214b, and 214c are buried inside the LTCC substrate, area size of the RF module 215a, 215b and 215c is efficiently reduced. The structure introduced in Fig. 3 is also applicable for the transmitters 230a to 230d, and the embodiment is similar to what was described previously.

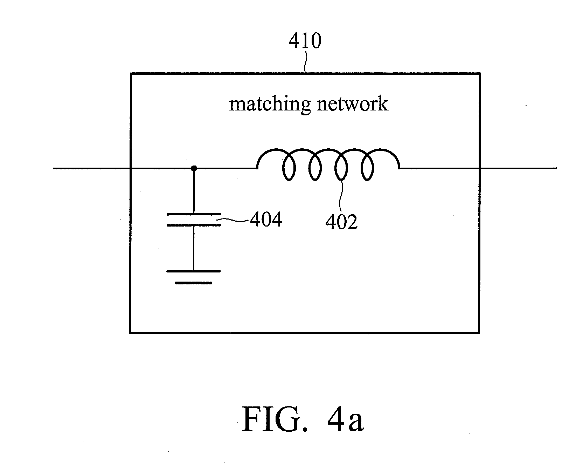

Fig. 4a shows an embodiment of a matching network 410. In the depth insides 222 and 252 as shown in Fig. 2, the structures of matching networks 212a and 232a are illustrated as the matching network 410, in which a inductor 402 and a capacitor 404 are deployed. The technique to bury the inductor 402 and capacitor 404 into the depth inside 222, is deemed as a prior art of the LTCC processes. With the LTCC technique, the inductor 402 and capacitor 404 can be accurately made with parameters of any required value. While a conventional architecture can only use inductors and capacitors of fixed values, the embodiment of the invention benefits from accuracy of impedance matching.

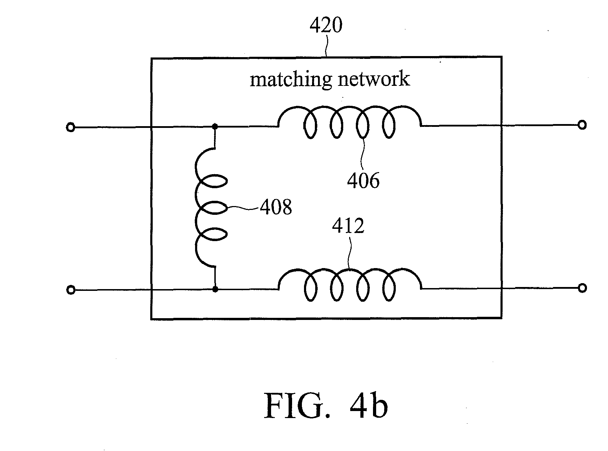

Fig. 4b shows an embodiment of a matching network 420. The matching network 420 is a differential pair, particularly applicable for the matching network 214a and 234a deposited in the depth insides 222 and 252 of Fig. 2. The matching network 420 comprises three inductors, in which the inductor 406 is parallel to the inductor 412, and the inductor 408 couples to both as a bridge. RF modules of different channels may require different parameters for impedance matching, and the inductors buried in the LTCC substrate can be accurately designed to achieve perfect impedance matching.

The major concept of the invention is to bury matching networks of RF modules into the LTCC substrate of a wireless communication device, such that components on the surface can be overlapped to reduce area size. Based on the architecture, parameters of matching networks can be accurately implemented as required, surpassing the limitations of conventional fixed value components. Accuracy is efficiently increased while cost is significantly reduced. Although the embodiment in Fig. 2 introduces a plurality of transmitters and receivers implemented together, the invention is not limited thereto. A single transmitter or receiver may also use the LTCC based architecture, with matching networks buried in the LTCC substrate. The communication protocol may include a wide variation such as WCDMA, CMDA2000, EV-DO&EV-DV, EDGE, GPRS. GSM, WiFi, WiMAX, A-GPS, GPS, BT, RFID, UWB, SDR, DVHB, DAB, FM, and etc.

While the invention has been described by way of example and in terms of preferred embodiment, it is to be understood that the invention is not limited thereto. To the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A wireless communication module, comprising:
an LTCC substrate, comprising at least first and second layers;
a first communication unit and a second communication unit deposited at the first layer;
a matching network deposited at the second layer, coupled to the first and second units to match impedances therebetween, such that signals are correctly transmitted to and from the first and second communication units.

2. The wireless communication module as claimed in claim 1, wherein the first layer is at the surface of the LTTC substrate, and the second layer is at a depth inside the LTCC substrate.

3. The wireless communication module as claimed in claim 1, wherein the matching network comprises at least an inductor or a capacitor embedded in the second layer.

4. The wireless communication module as claimed in claim 1, wherein the first and second communication units are selected from an LNA, a bandpass filter and a down conversion mixer.

5. The wireless communication module as claimed in claim 1, wherein the first and second communication units are selected from a power amplifier, a bandpass filter and an up conversion mixer.

6. A wireless communication device, comprising:
an antenna;
an LTCC substrate, comprising at least first and second layers; and
a plurality of receivers coupled to the antenna, wherein one of the receivers is deposited on the LTCC substrate, comprising a plurality of RF modules each associated with a channel, and one of the RF modules
comprises:
a first communication unit and a second communication unit deposited at the first layer; and
a matching network deposited at the second layer, coupled to the first and second units to match impedances therebetween, such that signals are correctly transmitted to and from the first and second communication units.

7. The wireless communication device as claimed in claim 6, wherein the first layer is at the surface of the LTTC substrate, and the second layer is at a depth inside the LTCC substrate.

8. The wireless communication device as claimed in claim 6, wherein the matching network comprises at least an inductor or a capacitor embedded in the second layer.

9. The wireless communication device as claimed in claim 6, wherein the first and second communication units are selected from an LNA, a bandpass filter and a down conversion mixer.

10. A wireless communication device, comprising:
an antenna;
an LTCC substrate, comprising at least first and second layers; and
a plurality of transmitters coupled to the antenna, wherein one of the transmitters is deposited on the LTCC substrate, comprising a plurality of RF modules each associated with a channel, and one of the RF modules comprises:
a first communication unit and a second communication unit deposited at the first layer; and
a matching network deposited at the second layer, coupled to the first and second units to match impedances therebetween, such that signals are correctly transmitted to and from the first and second communication units.

11. The wireless communication device as claimed in claim 10, wherein the first layer is at the surface of the LTTC substrate, and the second layer is at a depth inside the LTCC substrate.

12. The wireless communication device as claimed in claim 11, wherein the matching network comprises at least an inductor or a capacitor embedded in the second layer.

13. The wireless communication device as claimed in claim 10, wherein the first and second communication units are selected from a power amplifier, a bandpass filter and an up conversion mixer.

14. A wireless communication module, comprising:
an LTCC substrate, comprising at least first and second layers;
a first communication unit, a second communication unit and a third communication unit deposited at the first layer;
a first matching network deposited at the second layer, coupled to the first and second units to match impedances therebetween; and
a second matching network deposited at the second layer, coupled to the second and third units to match impedances therebetween.

15. The wireless communication module as claimed in claim 14, wherein:
the first communication units is an LNA or a power amplifier;
the second communication units is a bandpass filter; and
the third communication units is a down conversion mixer or an up conversion mixer.
